# EUROPEAN PATENT APPLICATION

(11) **EP 2 251 920 A1**
(43) Date of publication of application: **17.11.2010**
(21) Application number: 09425182.4
(22) Date of filing: 12.05.2009
(51) Int. Cl.: H01L 51/10

(54) **Method of manufacturing electrical contacts on organic semiconductors**

(71) Applicant: Università Degli Studi Di Milano - Bicocca, 20126 Milano (IT); Fondazione Cassa di Risparmio delle Province Lombarde, 20121 Milano (IT)
(72) Inventor: Campione, Marcello, 20043 Arcore (MI) (IT); Sassella, Adele, 23900 Lecco (IT); Moret, Massimo, 23807 Merate (Lecco) (IT); Braga, Daniele, 20050 Veduggio con Colzano (MI) (IT)
(74) Representative: Gerli, Paolo

(57) **Abstract**

A method for producing electrical contacts on organic semiconductors is described. The method, which involves low energy impact and can be carried out under ambient conditions, comprises covering the relevant surface of the semiconductor with a layer of an appropriate solvent such as water; an aluminium leaf having an appropriate thickness and work function containing metal oxide impurities is deposited onto the area treated in this manner. Electrical contacts with elevated conductivity are obtained by evaporating the solvent. One embodiment of the invention describes a family of crystalline semiconductors, preferably based on perylene or α-quaterthiophene, provided with the electrical contacts according to the method described herein and provided with particular structural characteristics.

## Description

### FIELD OF THE INVENTION

The present invention relates to the field of organic semiconductors and of the electronic and optoelectronic devices containing them.

### PRIOR ART

The performance of electronic and optoelectronic devices (solar cells, diodes, light-emitting diodes, transistors, sensors, etc.) is greatly influenced by charge transport properties in the semiconductor and by the interface characteristics between the semiconductor and the other components of the device. In particular in those devices using organic semiconductors, interface plays a fundamental role (J.Polymer.Sci.B: Polymer.Phys. 41 (2003) 2529). It has, for example, been shown in the case of organic light-emitting diodes that many performance-limiting factors are determined by problems at the interface between the semiconductor and the remainder of the device.

It is known to interpose contact materials (generally of a metallic nature) between the semiconductor and the other components of the device (generally electrodes) in order to avoid these problems. The contact material must have an appropriate work function, that is, the minimum energy required to extract an electron from its surface: for commonly used contact metals, the work function extends over a relatively narrow range, between approx. 3 and 6 eV; since the electron affinities and the ionisation potentials of the organic semiconductors often fall outside these values, it is desirable to extend the effective range of work functions for the contact metals.

There are two main approaches to covering the semiconductor with the contact material: *bottom contact,* on the basis of which the semiconductor is deposited on the surface of the metallic contact material, and *top contact,* which conversely provides for deposition of the metallic contact material onto the surface of the semiconductor.

In *bottom contact* methods, the quality of the interfaces is often suboptimal. In order to improve quality, it has been proposed to insert, between the metal and the semiconductor, an appropriate monomolecular layer (*self-assembled monolayer,* SAM) composed of compounds capable of modifying the electron structure of the interface and achieving a better alignment of the energy levels between the semiconductor (ionisation potential and electron affinity) and the metal (work function) (cf. for example Phys.Rev. B 54 (1996) R14321). These molecules are usually composed of an alkyl chain and two terminal groups, one of which reacts with the metallic surface and the other which controls the properties of the modified surface. US2007/0020798, for example, describes treating electrodes with a SAM and subsequently with metallic nanoparticles; a semiconductor is then deposited on the resulting surface; the layers are consolidated with a high temperature annealing procedure and the metal diffuses into the semiconductor.

*Bottom contact* methods have some limits: when the semiconductor is used in the form of individual crystals, which are simply arranged on the contacts, it is difficult to form a uniform contact surface. This does not occur if the organic material is deposited as a thin film; however, the morphology of the film is strongly influenced by the presence of the SAM which brings about a great increase in nucleation density at the organic/metal interface, with a consequent increase in the density of film defects and degradation of device performance.

In the alternative (*top contact)* approach, the metallic contacts are deposited directly onto the semiconductor, which may assume the form of individual crystals or a thin film. The most usual procedure involves evaporating the metal onto the surface of the sample by heating a metallic filament under a high vacuum. US2004/0033641 describes various high energy *top contact* metallisation processes which comprise a high temperature annealing phase to ensure a stable contact between the semiconductor and metal. US 5,622,895 describes semiconductor metallisation processes based on economically costly technologies such as thin film technology, vacuum evaporation, infrared irradiation, etc. In US 5,062,939, metallisation proceeds by means of heat treatment (e.g. 250°C) or by vapour deposition of the metal and this treatment is thus also potentially harmful to the semiconductor.

These solutions ensure good adhesion between the metallic layer and the surface of the sample; however, they result in mechanical damage of the semiconductor owing to the relatively high temperature reached in the deposition chamber (often greater than 100°C) and in changes to its electron structure owing to penetration of the metal into the volume of the sample (cf. J.Appl.Phys. 99, (2006) 094504; Appl.Surf.Sci., 211, (2003), 335). In particular for particularly thermally labile semiconductors, such as perylene or α-quaterthiophene, this procedure is completely unusable because the heating brings about substantial sublimation of the material and partial or total destruction of the original crystal structure with a consequent reduction in the structural performance (continuity of the active layer and flexibility) and charge transport performance of these materials.

Less aggressive methods are also available, such as ion beam assisted metallisation and contact lamination method (Natl.Acad.Sci.USA 99 (2002) 10252; Appl.Phys.Lett., 81 (2002) 562; Sci.Tech.Adv.Mat. 6 (2005) 97). The first technique is based on metal sublimation brought about by the interaction of the metallic surface with an ion beam (metal cations or electrons): while this procedure is indeed less aggressive, it does not eliminate the risk of structural damage and of diffusion of the metal atoms into the semiconductor. The contact lamination method is based on the deposition of the metallic contacts onto an elastomeric support; the assembly is then brought into conforming contact with the semiconductor supported on an appropriate substrate, and the metal is transferred from the elastomer onto the semiconductor: lamination is brought about solely by Van der Waals attraction forces. This method involves less damage to the surface of the organic material and reduced diffusion of metal atoms into the organic layer. However, it remains significantly limited with regard to resolution and reproducibility; furthermore, transfer of the metal from the elastomer to the semiconductor is not always ideal and may result in a discontinuity in the coverage of the latter.

Finally, all lamination processes entail the use of high purity metals comprising absolutely no surface oxides, because the latter are known to be non-conductive and thus considered to perform poorly as interfaces (Appl.Phys.Lett. 89 (2006) 123508).

The above-stated examples demonstrate how difficult it is to obtain metallic contacts for semiconductors by a straightforward and inexpensive process which ensures adequate conductivity at the interface while simultaneously respecting the structural integrity of the semiconductor. These requirements are particularly urgent in the case of crystalline semiconductors such as perylene or α-quaterthiophene, which are typically thermally labile, and thus easily damaged by normal metallisation processes.

### DESCRIPTION OF THE FIGURES

Figure 1: Molecular structures (top), contact surface of the individual grown crystal (middle) and device configuration (bottom) for rubrene (orthorhombic polymorph), perylene (monoclinic α polymorph) and α-quaterthiophene (low-temperature monoclinic polymorph).
Figure 2: Current/voltage characteristics of diodes based on a) rubrene, b) perylene, c) α-quaterthiophene. The inserts in plates a) and b) show the graph on a semilogarithmic scale. The curve in plate c) was recorded under AM 1.5 solar illumination (80 mW/cm²).

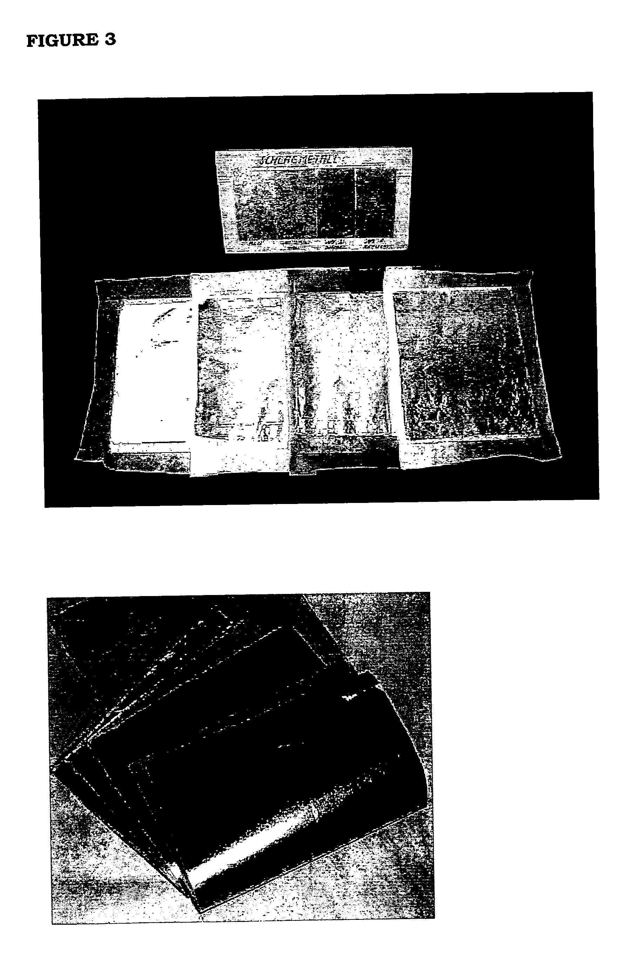

Figure 3: Examples of metal leaves (Erich Dungl GmbH) usable in the present invention.

### BRIEF DESCRIPTION OF THE INVENTION

A method, which is provided by the present invention, has now been found for producing electrical contacts on organic semiconductors, which method is capable of ensuring appropriate interfacial conductivity between the semiconductor and the remainder of an electronic or optoelectronic device containing it. The method involves covering the relevant surface of the semiconductor with a layer of water or other appropriate solvent, then depositing on the semiconductor treated in said manner a metal leaf having an appropriate thickness and work function which is covered with its native oxide.

It has been observed that interposing a layer of solvent, combined with the thinness of the metal leaf and with the oxide contamination on its surface, is sufficient to form a stable and long-lasting contact. It has furthermore been observed that the interface produced in this manner exhibits conductivity characteristics of the same order as those produced with pure metals. These observations have been used as the basis for developing a highly effective process for producing electrical contacts on semiconductors. The process, which may advantageously be carried out under ambient conditions, avoids the use of elevated temperatures and fully preserves the structure of the semiconductor. In the case of thermally labile crystalline semiconductors (in particular perylene, α-quaterthiophene), metallic contacts can be produced without in any way modifying the original crystal structure of the semiconductor. Furthermore, the process allows the use of metal leaves with a low degree of purity, as commonly used in other industrial sectors (in particular in the field of restoration, fine arts or craft trades).

In summary, the simplicity of implementing the process, its performance under ambient conditions and the use of low cost metallic materials combine to make the process described here economically competitive; at the same time, preservation of the structure of the semiconductor and the identified high interfacial conductivity demonstrate its qualitative worth.

### DETAILED DESCRIPTION OF THE INVENTION

For the purposes of the present invention, an "electrical contact" is defined as the assembly of the surface of a semiconductor and the metallic layer covering it. When the semiconductor is used as a component in electronic or optoelectronic devices, the metal layer performs the function of an interface between the semiconductor and the other elements of the (opto)electronic device, ensuring the necessary electrical conductivity.

The phrase "consistently crystal structure" denotes a material consistently organised in crystals in all parts.

The process according to the invention comprises the deposition of a layer of solvent onto the surface of the semiconductor involved in producing the electrical contact. A metal leaf having a desired surface with specific characteristics as described below is then applied onto the surface treated in this manner. After appropriate evaporation of the solvent, a semiconductor stably covered with the metal leaf is obtained, which has excellent conductivity at the interface and excellent functional properties within (opto)electronic devices which are comparable or better than those of known devices. The entire process may conveniently be carried out at ambient temperature, pressure and humidity (for example 15-30°C).

The organic semiconductor may be selected from among those used in the electronic and optoelectronic device sector, or any other material with similar conduction properties. Preferred semiconductors are those with a consistent crystal structure, such as to ensure solvent impermeability. Although the claimed invention is described in relation to the production of contacts on low molecular weight organic semiconductors, it is understood also to be applicable to any other type of organic semiconductor.

The solvent may be any polar solvent (or mixtures thereof) in which the semiconductor is insoluble, typically water; although not essential for the purposes of the invention, the solvent may contain one or more additives used in the sector: for example adhesion-promoting substances, substances effective in further increasing charge carrier injection, stabilisers, etc.

The solvent may be deposited by means of any available method. For example, when the semiconductor is in the form of a continuous layer (film or other continuous surface), deposition may proceed by atomisation, spray coverage, ink-jet, exposure to a solvent-saturated atmosphere, condensation by temperature differential, mechanical treatment of the surface with solvent-soaked supports or submersion of the semiconductor in the solvent in question, spraying, etc. When the semiconductor to be covered is composed of one or more individual crystals, deposition may also proceed by using micropipettes or similar systems. At the time of application, it is preferable for there to be an interlayer of solvent between the metal leaf and semiconductor; the layer thickness of solvent is generally between 100 and 500 micrometres, but other thicknesses may be used. Subsequently, on evaporation of the solvent interlayer, the metal leaf adheres, conforming perfectly, to the surface of the semiconductor creating excellent adhesion of the order of that achievable by means of standard contact lamination methods, while avoiding any application of pressure to the surface of the semiconductor.

The metal leaf used is composed of metals having a work function compatible with the functional requirements of the electronic or optoelectronic device in question. Typically, the work function is comprised between 3 and 6 eV. Examples of metals having the above-stated characteristics are gold, copper, silver and aluminium; aluminium is preferred because it combines an optimal work function with a low metal cost. The thickness of the leaf is generally less than 500 nanometres; effective reference ranges are for example 100-500 nanometres, 100-300 nanometres, etc.; adhesion to the semiconductor is increased with lower metal thicknesses. Another characteristic of the metal leaf is that its surface (and in particular its "lower" surface, i.e. that intended to come into contact with the semiconductor) exhibits surface oxidation impurities. It has in fact been observed that such impurities contribute to ensuring good adhesion between the metal and the semiconductor while simultaneously not significantly limiting conductivity at the interface. It is not necessary to carry out specific oxidation pre-treatments of the metal leaf, because even traces of oxide usually obtainable by exposing the leaf to air and to ambient humidity (native oxide) are sufficient for carrying out the required function. By way of non-limiting reference, the ratio between the weight of the metal oxide and the lower surface of the leaf containing it is generally comprised between 0.8 and 1.4 µg/cm², preferably between 0.4 and 1.2 µg/cm², more preferably between 0.2 and 0.8 µg/cm². On the basis of this invention, it is now possible to make use of metal leaves with a moderate degree of purity already known in other technical fields as contact materials for semiconductors; such materials, never used in semiconductor technology, may be for example hammered leaf metals (or *gold leaf, aluminium leaf, imitation gold leaf*), known in the restoration, fine arts and craft trades sector. Examples of these products are those distributed by Erich Dungl GmbH (AU), Easy Leaf Products (US), Fabbriche Riunite Metalli S.p.A. (IT), Masserini Srl., Abbiategrasso (IT). It has been observed that such products, despite exhibiting a moderate load of surface oxidation, are entirely capable of providing effective and stable contacts on semiconductors in (opto)electronic devices. Use may thus unexpectedly be made of these traditional, low cost materials. One aspect of the invention accordingly involves using metal leaves, partially oxidised at least on their lower surface, in the production of electrical contacts for organic semiconductors. In accordance with the preceding description, such metal leaves preferably have one or more of the following characteristics: they are composed of gold, copper, silver, aluminium; they have a work function comprised between 3 and 6 eV; they have a thickness of less than 500 nanometres; they are materials used in the restoration, fine arts or craft trades sector; they are selected from among *imitation gold leaf, gold leaf* and similar products.

Deposition of the metal leaf onto the semiconductor may proceed manually or automatically using dedicated equipment in accordance with per se known methods. After deposition, the semiconductor is left for an appropriate period (for example 4 hours) in contact with the atmosphere, conveniently at ambient temperature, humidity and pressure, to allow the solvent to evaporate; this phase may optionally be accelerated by exposing the product to a stream of nitrogen or other inert gas, or by exposure to a vacuum or reduced atmospheric pressure. The present process is applicable to the production of metallic contacts on any semiconductor of use for producing any (opto)electronic device, for example solar cells, photovoltaic cells, transistors, diodes, light-emitting diodes, sensors, etc. The present invention is particularly suited to producing contacts on extensive surfaces which do not require patterning, such as for example the case of semiconductors used in solar and photovoltaic cells; in the case of contacts which require specific patterning, the process will include suitable per se known steps for producing selective metallisations, for example by using appropriate masks or prior profiling of the metal to be applied, by using appropriate microfluidic systems, etc., or by selective removal, achieved with masks or equivalent systems, of the unnecessary parts of the applied leaf, said removal being carried out in the period immediately subsequent to lamination, i.e. when the solvent is still present in a substantial quantity and adhesion is not yet final. When producing solar or photovoltaic cells and similar apparatuses, the semiconductor will be further provided with other elements typical and usual in the sector, for example the surface exposed to sunlight will preferably be provided with a layer of transparent conductive oxide, for example indium and tin oxide; similar considerations apply to the production of the other (opto)electronic devices mentioned above.

Thanks to the present invention, it has been possible to bring about a major simplification of *top contact* type deposition processes, so resulting in fundamental cost reductions: lamination by interposition of water or other solvents, which can conveniently be carried out under ambient conditions, avoids the need to use costly processes such as metal sublimation or evaporation; furthermore, the lower metal purity requirement allows lower cost metallic materials, which have never before been described for use in the semiconductor field, to be used in this application. The described technology furthermore combines elevated charge transfer efficiency with a process having low energy impact, so ensuring overall preservation of the mechanical properties of the semiconductor. The process may be applied to any semiconductor. Forming metallic contacts according to the described process permits sufficient injection/extraction of charge carriers into/from the organic material and at the same time maximally preserves the mechanical properties of the semiconductor. In this manner, electronic or optoelectronic devices exhibiting good performance and low vulnerability are obtained. The particularly mild conditions for producing the electrical contact have in particular made it possible to obtain organic semiconductor devices using typically thermally labile crystalline organic materials (perylene and α-quaterthiophene): in such products, the semiconductor substantially retains its original crystal structure. These semiconductors as such, appropriately provided with electrical contacts, are further provided by the invention.

The invention will now be described in non-limiting manner with reference to the following examples.

### EXPERIMENTAL SECTION

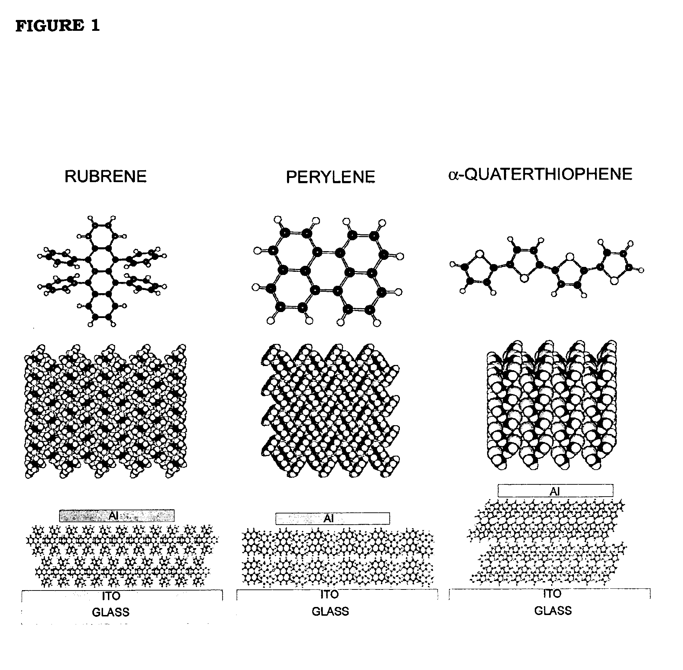

Commercial powders of rubrene, perylene, α-quaterthiophene were purified by various sublimation phases prior to use. Individual crystals were grown from the vapour phase as described in R.A. Laudise et al., J.Crystal Growth, 187, 1998, 449, then placed on a glass slab coated with indium and tin dioxide (ITO) (Fig. 1). Individual crystals are obtained in the form of thin flakes a few millimetres wide and approx. 1 micrometre thick which exhibit a clean, planar surface at the molecular level which does not require cleaving before use.

A small drop of triple-distilled water (approx. 10 µl) is placed on the surface of the crystal. A piece of aluminium leaf (Blattaluminium, Erich Dungl GmbH (AU), approx. 4 mm²) is placed on the surface of the water drop and the sample is then left to dry slowly overnight in a chamber maintained in a nitrogen atmosphere. The resultant assembly coheres and has appropriate adhesion.

The metallic contacts are then characterised by recording current/voltage (I-V) characteristics in air with a Keithley 4200-SCS instrument, using a tungsten tip to contact the ITO surface and a gold wire to contact the side with aluminium. It is observed that, in the configuration used (see Fig. 1), current flow is severely disadvantaged, since the charge carriers must follow channels which are orthogonal to the molecular layer, in which superposition of the n orbitals is negligible. In particular, the I-V characteristics shown for perylene and α-quaterthiophene have never previously been reported in the literature.

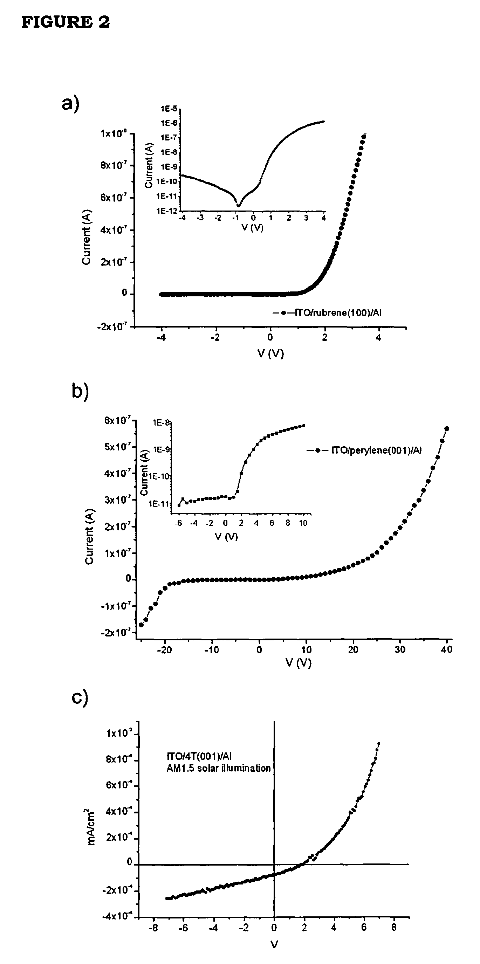

As may be seen in Figure 2a, the I-V characteristics of the ITO/rubrene(100)/Al device exhibits the known rectification behaviour, i.e. a low current for inverse polarisation and an elevated current for direct polarisation. When low negative voltages are applied, an ohmic contribution, which is symmetrical and probably due to loss phenomena (Polymer International, 55 2006, 583), is followed by an exponential increase in the current, describable on the basis of the thermionic-diffusion theory (S.M. Sze, Physics of Semiconductor Devices, John Wiley, New York, 1981). At higher voltage, the current profile arises from the superposition of two contributions, one deriving from the metal/semiconductor interface, the other from the volume. The latter is associated with the non-empty region of the semiconductor and results in a downward deflection of the I-V characteristics at voltages of above 1.5 V. In this case, the likely current profile is proportional to the square of the voltage due to spatial charge effects.

Similar behaviour was found for the ITO/perylene(001)/Al characteristics shown on a linear and semilogarithmic scale in Figure 2b). In this case, the ohmic contribution at low negative voltages is not detected (inset) and, at voltages below -20 V, an inverse loss current is observed to occur.

Within the voltage range investigated, the diodes made with α-quaterthiophene exhibit currents below the sensitivity of the instrument under conditions of darkness or ambient illumination. Figure 2c shows I-V characteristics under AM 1.5 solar illumination conditions. The rectifying behaviour of the device is clear under these conditions; furthermore the device exhibits clear photovoltaic behaviour, the short-circuit photocurrent in fact being 2×10⁻⁹ A (current density 7×10⁻⁵ mA/cm²) and the open-circuit voltage being 1.7 V. The estimated power conversion efficiency of the diode is of the order of 10⁻⁴%.

The above data show that the metallic contacts made with the present process preserve the structural characteristics of the organic active material and allow effective charge injection/extraction. The I-V characteristics shown here demonstrate clear diode behaviour and a good response at elevated voltages. At variance with prior publications which emphasise the necessity of metal purity (*Appl.Phys.Lett,* op.cit.), the present results demonstrate the favourable effect of the presence of a layer of native oxide at the interface between the semiconductor and the metallic contact. The aluminium leaf was in fact used in crude form, without any specific pre-treatments. The level of adhesion achieved proved to be comparable with that achieved by means of conventional contact lamination methods.

## Claims

1. A process for producing electrical contacts on the surface of an organic semiconductor, comprising the steps of:
(a) depositing a layer of solvent onto the surface of the semiconductor;
(b) depositing onto the surface treated in said manner a metal leaf which is partially oxidised at least on its lower surface;
(c) evaporating the solvent.

2. Process according to claim 1, wherein the metal leaf is a gold, copper, silver or aluminium leaf.

3. Process according to claims 1-2, wherein the metal leaf has a work function comprised between 3 and 6 eV.

4. Process according to claims 1-3, wherein the metal leaf has a thickness of less than 500 nanometres.

5. Process according to claims 1-4, wherein the metal leaf is a material which is already known in the restoration, fine arts or craft trades sector.

6. Process according to claim 5, wherein the metal leaf is selected from among *imitation gold leaf, gold leaf, aluminium leaf* and similar materials.

7. Process according to claims 1-6, wherein the solvent is water.

8. Process according to claims 1-7, carried out at ambient temperature, pressure and humidity.

9. Process according to claims 1-8, wherein the semiconductor used has a consistent crystal structure and retains it throughout the whole process.

10. Process according to claims 1-9, wherein the semiconductor is selected from among rubrene, α-quaterthiophene, perylene or mixtures thereof.

11. Process according to claims 1-10, wherein the semiconductor is incorporated into an electronic or optoelectronic device.

12. Use of partially oxidised metal leaves in accordance with claims 1-6 in producing electrical contacts on the surface of an organic semiconductor.

13. An organic semiconductor provided with electrical contacts, produced in accordance with the process according to claims 1-11.

14. Semiconductor according to claim 13 having a consistent crystal structure.

15. Semiconductor according to claim 14, wherein the crystal structure is monoclinic.

16. Semiconductor according to claim 15, composed of perylene and/or α-quaterthiophene.

17. An electronic or optoelectronic device comprising an organic semiconductor provided with electrical contacts, said contacts being produced by means of the process according to claims 1-11.

18. Device according to claim 17, wherein the semiconductor has a consistent crystal structure.

19. Device according to claim 18, wherein the crystal structure is monoclinic.

20. Device according to claim 19, wherein the semiconductor is composed of perylene and/or α-quaterthiophene.

21. A process for manufacturing electronic or optoelectronic devices comprising the step of including, in said device, an organic semiconductor provided with electrical contacts produced in accordance with claims 1-11.
